# EUROPEAN PATENT APPLICATION

(11) **EP 4 790 431 A1**
(43) Date of publication of application: **12.08.2026**
(21) Application number: 26155977.7
(22) Date of filing: 03.02.2026
(51) Int. Cl.: G01R 19/165

(54) **METHOD, APPARATUS AND SYSTEM FOR DETECTING TAIL CURRENT IN CURRENT TRANSFORMER (CT)**

(30) Priority: 05.02.2025 IN 202541009598
(71) Applicant: ABB Schweiz AG, 5400 Baden (CH)
(72) Inventor: VALSAN, Simi, 683108 Aluva (IN)
(74) Representative: Zimmermann & Partner Patentanwälte mbB

(57) **Abstract**

The present disclosure relates to field of electrical engineering that discloses method, tail current detection unit and an Intelligent Electronic Device (IED) comprising the tail current detection unit for detecting tail current in CT. The tail current detection device obtains real-time current values of current flowing. Further, tail current detection unit determines instant time constant (Kₜ). Thereafter, tail current detection unit determines deviation value (ΔKₜ) by using pair of consecutive time constants. Furthermore, tail current detection unit compares deviation value (ΔKₜ) with predefined deviation threshold. Thereafter, based on comparison, tail current detection unit performs one of, incrementing counter each time when deviation value (ΔKₜ) is less than predefined deviation threshold in consecutive time instances and resetting counter to zero when deviation value (ΔKₜ) is greater than predefined deviation threshold. Finally, tail current detection unit detects presence of tail current in CT when counter exceeds predefined count threshold. Present disclosure provides advantage of avoiding false alarms due to tail current.

## Description

### TECHNICAL FIELD

The present disclosure relates to electrical engineering. Particularly, the present disclosure relates to a method and apparatus for detecting tail current in a Current Transformer (CT).

### BACKGROUND

Current Transformer (CT) is a device that measures electrical current flowing through a conductor or a power system. In the normal CTs (i.e., the CTs without air gap), in case of a short-circuit incident, the short-circuit current will reach tens of times or even hundreds of times of CT rated current, leading to CT saturation. In such situation, the CT cannot transfer the primary current correctly to a secondary side in the CT, which causes mis-operation or mal-operation of protection equipment and greater errors of fault location equipment. To overcome such situations, manufacturers open a small air gap on the core of CT. The air-gapped CT can guarantee that the errors are within the permissible range of the relay protection in the steady state and the transient state.

However, in the air-gapped CT, when the core flux decays to its final value after fault interruption, the energy stored in the magnetic circuit must be dissipated in the secondary circuit and results in a unidirectional discharge of long duration. Since the change in flux required to reach the remanence level is greater for the air-gapped CT, the discharge voltage is higher due to which the time of decay is very long. This results in CT secondary current tailing phenomenon, which is known as current tail. Since the time of decay is very long, this may not give an indication that circuit breaker is open. In other words, the decay current following fault interruption may delay in indicating that the circuit breaker is open. This can cause a false operation of the breaker failure protection. In other words, the current tail may impact the operations of the breaker failure protection, which may eventually lead to generation of false alarms. Hence, it becomes necessary to mitigate the issues caused by the current tail. Therefore, there is a need to detect the current tail in the CT to avoid false alarms.

The information disclosed in this background of the disclosure section is only for enhancement of understanding of the general background of the invention and should not be taken as an acknowledgement or any form of suggestion that this information forms the prior art already known to a person skilled in the art.

### SUMMARY

Disclosed herein is a method of detecting tail current in a Current Transformer (CT). The method comprises obtaining real-time current values of current flowing in a secondary side of the CT. Further, the method comprises determining an instant time constant (Kₜ). The instant time constant (Kt) is ratio of instant current value (Iₜ) at a specific time instance (t) and current value (Iₜ₋₁) at preceding time instance (t-1). Thereafter, the method comprises determining a deviation value (ΔKₜ) by using pair of consecutive time constants. The pair of consecutive time constants are the instant time constant (Kt) at the specific time instance (t) and a time constant (Kₜ₋₁) at preceding time instance (t-1). Furthermore, the method comprises comparing the deviation value (ΔKₜ) with a predefined deviation threshold to determine whether the deviation value (ΔKₜ) is less than the predefined deviation threshold. Thereafter, based on comparison, the method comprises performing one of, incrementing a counter each time when the deviation value (ΔKₜ) is less than the predefined deviation threshold in consecutive time instances and resetting the counter to zero when the deviation value (ΔKₜ) is greater than the predefined deviation threshold. Finally, the method comprises detecting presence of tail current in the CT when the counter exceeds a predefined count threshold.

Further, disclosed herein is a tail current detection unit for detecting tail current in a Current Transformer (CT). The tail current detection unit comprises a processor and a memory. The memory is communicatively coupled to the processor and stores processor-executable instructions, which on execution, cause the processor to obtain real-time current values of current flowing in a secondary side of the CT. Further, the processor determines an instant time constant (Kt). The instant time constant (Kt) is ratio of instant current value (Iₜ) at a specific time instance (t) and current value (Iₜ₋₁) at preceding time instance (t-1). Thereafter, the processor determines a deviation value (ΔKₜ) by using pair of consecutive time constants. The pair of consecutive time constants are the instant time constant (Kt) at the specific time instance (t) and a time constant (Kₜ₋₁) at preceding time instance (t-1). Furthermore, the processor compares the deviation value (ΔKₜ) with a predefined deviation threshold to determine whether the deviation value (ΔKₜ) is less than the predefined deviation threshold. Thereafter, based on comparison, the processor performs one of, incrementing a counter each time when the deviation value (ΔKₜ) is less than the predefined deviation threshold in consecutive time instances and resetting the counter to zero when the deviation value (ΔKₜ) is greater than the predefined deviation threshold. Finally, the processor detects presence of tail current in the CT when the counter exceeds a predefined count threshold.

Furthermore, disclosed herein is an Intelligent Electronic Device (IED) for detecting tail current in a Current Transformer (CT). The IED comprises an Analog to Digital Converter (ADC), a system measurement, one or more protection functions, and a tail current detection unit. The tail current detection unit is configured to obtain real-time current values of current flowing in a secondary side of the CT. The real-time current values are measurements of current. Further, the tail current detection unit determines an instant time constant (Kt). The instant time constant (Kt) is ratio of instant current value (It) at a specific time instance (t) and current value (Iₜ₋₁) at preceding time instance (t-1). Thereafter, the tail current detection unit determines a deviation value (ΔKₜ) by using pair of consecutive time constants. The pair of consecutive time constants are the instant time constant (Kt) at the specific time instance (t) and a time constant (Kₜ₋₁) at preceding time instance (t-1). Furthermore, the tail current detection unit compares the deviation value (ΔKₜ) with a predefined deviation threshold to determine whether the deviation value (ΔKₜ) is less than the predefined deviation threshold. Thereafter, based on comparison, the tail current detection unit performs one of, incrementing a counter each time when the deviation value (ΔKₜ) is less than the predefined deviation threshold in consecutive time instances and resetting the counter to zero when the deviation value (ΔKₜ) is greater than the predefined deviation threshold. Finally, the tail current detection unit detects presence of tail current in the CT when the counter exceeds a predefined count threshold.

The foregoing summary is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE ACCOMPANYING DRAWINGS

The accompanying drawings, which are incorporated in and constitute a part of this disclosure, illustrate exemplary embodiments and, together with the description, explain the disclosed principles. In the figures, the left-most digit(s) of a reference number identifies the figure in which the reference number first appears. The same numbers are used throughout the figures to reference like features and components. Some embodiments of the system and/or methods in accordance with embodiments of the present subject matter are now described, by way of example only, and regarding the accompanying figures, in which:
**FIG. 1A** shows an exemplary architecture to implement techniques for detecting tail current in a Current Transformer (CT), in accordance with some embodiments of the present disclosure;
**FIG. 1B** shows an exemplary architecture having an Intelligent Electronic Device (IED) comprising an tail current detection unit, in accordance with some embodiments of the present disclosure;
**FIG. 1C** shows an exemplary architecture comprising a tail current detection unit, a switch and breaker failure protection, in accordance with some embodiments of the present disclosure;
**FIG. 2** shows an exemplary graphs illustrating current, instant time constant (Kₜ), a deviation value (ΔKₜ) and current tail indication, in accordance with some embodiments of the present disclosure;
**FIG. 3A-3D** shows an exemplary graphs comparing issuing of re-trip/backup trip signal in existing implementation and present implementation, in accordance with some embodiments of the present disclosure;
**FIG. 4** shows a detailed block diagram of a tail current detection unit for detecting tail current in a Current Transformer (CT), in accordance with some embodiments of the present disclosure; and
**FIG. 5** shows a flowchart illustrating a method of detecting tail current in a Current Transformer (CT), in accordance with some embodiments of the present disclosure.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and executed by a computer or processor, whether such computer or processor is explicitly shown.

### DETAILED DESCRIPTION

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

While the disclosure is susceptible to various modifications and alternative forms, specific embodiment thereof has been shown by way of example in the drawings and will be described in detail below. It should be understood, however that it is not intended to limit the disclosure to the specific forms disclosed, but on the contrary, the disclosure is to cover all modifications, equivalents, and alternative falling within the scope of the disclosure.

The terms "comprises", "comprising", "includes", or any other variations thereof, are intended to cover a non-exclusive inclusion, such that a setup, device, or method that comprises a list of components or steps does not include only those components or steps but may include other components or steps not expressly listed or inherent to such setup or device or method. In other words, one or more elements in a system or apparatus proceeded by "comprises... a" does not, without more constraints, preclude the existence of other elements or additional elements in the system or method.

As outlined in the background section, instantaneous current in a Current Transformer (CT) excitation branch and secondary winding may not be zero at the moment that the primary device cut off. The energy storage in the inductance will slowly release through a secondary circuit formed by resistance and inductance. This results in the CT secondary current tailing phenomenon, which is known as current tail. Since the inductance is large, a damp time constant of the secondary circuit is large, usually several hundred milliseconds to a few seconds. The CT tail current is mainly consisting of a damping aperiodic component. As the decay current following fault interruption may delay in indicating that the circuit breaker is open, this may cause false operation interrupting complete power system. The present disclosure proposes method and device to detect the tail current in the CT to avoid the scenario of false alarms.

According to the present disclosure, an Intelligent Electronic Device (IED) for detecting tail current in a Current Transformer (CT) is disclosed. The IED comprises an Analog to Digital Converter (ADC), a system measurement, one or more protection functions, and a tail current detection unit. The tail current detection unit may obtain real-time current values of current flowing in a secondary side of the CT. The real-time current values are measurements of current. Upon obtaining the real-time current values, the tail current detection unit may determine an instant time constant (Kₜ). The instant time constant (Kₜ) may be ratio of instant current value (Iₜ) at a specific time instance (t) and current value (Iₜ₋₁) at preceding time instance (t-1). Thereafter, the tail current detection unit may compare the deviation value (ΔKₜ) with a predefined deviation threshold to determine whether the deviation value (ΔKₜ) is less than the predefined deviation threshold. Based on the comparison, the tail current detection unit may perform one of, incrementing a counter each time when the deviation value (ΔKₜ) is less than the predefined deviation threshold in consecutive time instances and resetting the counter to zero when the deviation value (ΔKₜ) is greater than the predefined deviation threshold. Finally, the tail current detection unit may detect presence of tail current in the CT when the counter exceeds a predefined count threshold. The present disclosure also detects end of tail current, which is discussed below in detail.

In the following detailed description of the embodiments of the disclosure, reference is made to the accompanying drawings that form a part hereof, and in which are shown by way of illustration specific embodiments in which the disclosure may be practiced. These embodiments are described in sufficient detail to enable those skilled in the art to practice the disclosure, and it is to be understood that other embodiments may be utilized and that changes may be made without departing from the scope of the present disclosure. The following description is, therefore, not to be taken in a limiting sense.

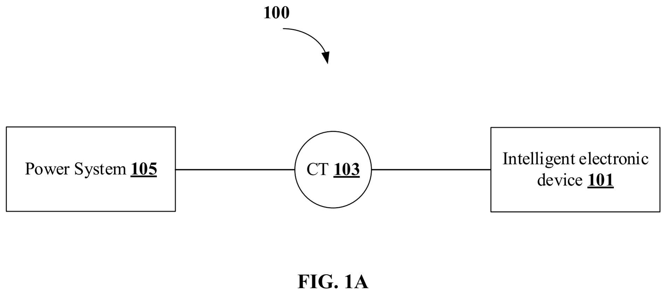

**FIG. 1A** shows an exemplary architecture **100** to implement techniques for detecting tail current in a Current Transformer (CT), in accordance with some embodiments of the present disclosure.

The exemplary architecture **100** comprises an Intelligent Electronic Device (IED) **101,** a Current Transformer (CT) **103** and a power system **105.** In an embodiment, the IED **101** may be electrically coupled with the CT **103.** In an embodiment, the CT **103** may be configured to measure electrical current flowing through a power system **105.** In an embodiment, the power system **105** may be a network of electrical components designed to generate, transmit, and distribute electrical energy. In some embodiments, the power system **105** may be an electrical system or a combination of electrical systems. As an example, the power system **105** may be, without limitation, an electrical grid, an on-grid solar power system, a hybrid power system, In an embodiment, the CT **103** may be electrically coupled with the power system **105** to obtain real-time current values of current flowing through the power system **105.**

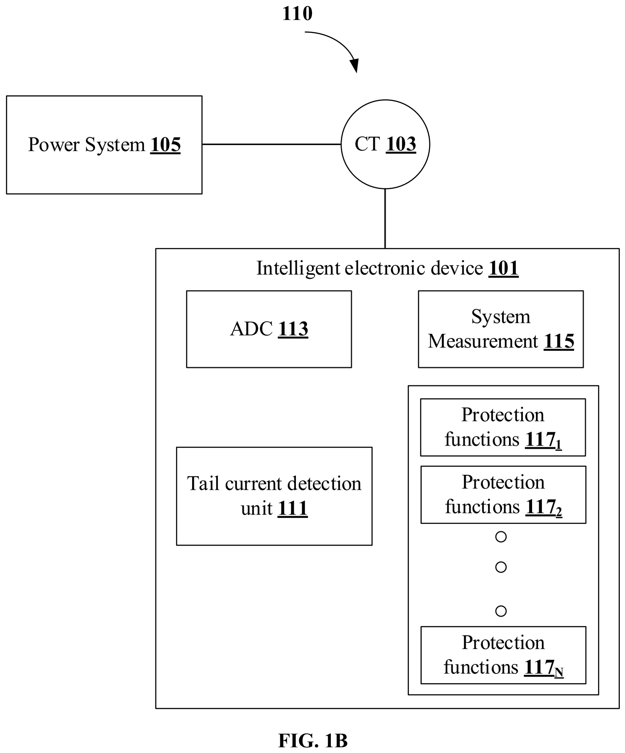

**FIG. 1B** illustrates an exemplary architecture of the IED **101.** The IED **101** may be alternatively referred as a relay which can detect, monitor and control a power system. The IED **101** issues TRIP commands to a circuit breaker on detecting fault conditions. The IED **101** may include, without limitation, a tail current detection unit **111,** an Analog to Digital Converter (ADC) **113,** a system measurement **115** and one or more protection functions **117_{N}.** The ADC **113** may be used to convert analog current signals from the CT **103** to digital values. The system measurement **115** may be used for protection of power system **105,** monitoring and controlling of the power system **105,** and data logging and analysis in the IED **101.** The one or more protection functions **117_{N}** may be used for protection of the power system **105** associated with the IED **101.** In an embodiment, the IED **101** may be configured to detect tail current in the CT **103** using the tail current detection unit **111.** The IED **101** may be used as a standalone system or as an application to perform an action disclosed in present disclosure.

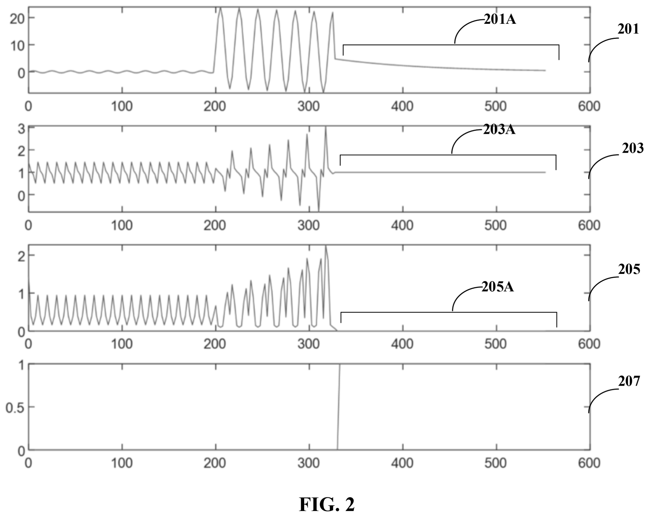

In an embodiment, the tail current detection unit **111** may be configured to obtain real-time current values of current flowing in a secondary side of the CT **103.** The real-time current values are measurements of the current. In an embodiment, the secondary side of the CT **103** provides measurement of the real-time current flowing in the power system **105.** In an embodiment, the tail current detection unit **111** may obtain the real-time measurements upon activation of a trip signal by the one or more protection functions **117_{N}** of the IED **101.** The IED **101** may be electrically coupled with the CT **103** (as illustrated in **FIG. 1B****)**. In an embodiment, the one or more protection functions **117_{N}** may be used for protection of the power system **105** associated with the IED **101.** As an example, the one or more protection functions **117_{N}** may include, without limitation, overcurrent protection, earth fault protection, differential protection, distance protection, voltage protection, frequency protection and power swing protection. In an embodiment, the activation of trip signal may indicate an abnormal condition or fault which may be required to be addressed. **FIG. 2** illustrates exemplary graphs, graph **201 in** **FIG. 2** illustrates the real-time current values of current flowing in a secondary side of the CT **103.** The current tail i.e., a decaying waveform that resembles a tail is represented by **201A in** **FIG. 2****.**

Referring back to **Fig. 1A****,** upon obtaining the real-time current values, the tail current detection unit **111** may determine an instant time constant (Kt). The instant time constant (Kt) may be ratio of instant current value (Iₜ) at a specific time instance (t) and current value (Iₜ₋₁) at preceding time instance (t-1). In an embodiment, the preceding time instance (t-1) may be a time instance which is prior to the specific time instance (t). As an example, time difference between the specific time instance (t) and the preceding time instance (t-1) may be in a range of 500 microseconds to 1.5 milliseconds. The value of the time difference should not be construed as a limitation and the value of the time difference may vary. As an example, the instant time constant (Kt) may be ratio of current value at time 10 milliseconds and current value at time 9 milliseconds. As an example, equation 1 below shows the instant time constant (Kₜ): ${K}_{t} = {I}_{t} / {I}_{t - 1}$

The Equation 1 provided above is intended as an illustrative example and should not be construed as a limitation of the present disclosure. The graph **203 of** **FIG. 2** illustrates the instant time constant determined using the current values. In an embodiment, the instant time constant (Kt) may be determined continuously as the values may be used for further determination.

In an embodiment, upon determining the instant time constant (Kt), the tail current detection unit **111** may be configured to determine a deviation value (ΔKₜ) by using pair of consecutive time constants. The pair of consecutive time constants may be the instant time constant (Kt) at the specific time instance (t) and a time constant (Kₜ₋₁) at preceding time instance (t-1). Similar to determining the instant time constant (Kt), the deviation value (ΔKₜ) may be determined using difference between the instant time constant (Kₜ) at the specific time instance (t) and the time constant (Kₜ₋₁) at preceding time instance (t-1). In an embodiment, as the values of the instant time constant (Kₜ) are determined continuously, the deviation value (ΔKₜ) may be determined using difference between the instant time constant (Kₜ) at the specific time instance (t) and the time constant (Kₜ₋₁) at preceding time instance (t-1). As an example, equation 2 below shows the deviation value (ΔKₜ): ${ΔK}_{t} = \left|{K}_{t}-{K}_{t - 1}\right|$

The Equation 2 provided above is intended as an illustrative example and should not be construed as a limitation of the present disclosure. The graph **205** of **FIG. 2** illustrates the deviation value (ΔKₜ) determined using the instant time constant values. In an embodiment, the deviation value (ΔKₜ) may be determined continuously as the values may be used for further determination. In an embodiment, the real-time current values may vary based on the power system 105, due to which the instant time constant (Kt) may also vary. Since, the instant time constant (Kt) may vary, determining the current tail based on the instant time constant (Kt) may be difficult as the constant value which indicates the current tail may not be defined. For instance, referring to graph **203** in **FIG.2****,** which indicates instant time constant (Kt) of the current tail is at a value '1', i.e., the straight line **203A** indicating current tail time constant is constant at value '1'. In other words, normal working of the CT **103** may be identified based on a sinusoidal waves in the graph. Since the current tail is formed due to decay of the current in the secondary side of the CT **103,** this may be identified based on a decaying line that reflects a consistent reduction over time.

To overcome the challenges faced in detecting current tail, the tail current detection unit **111** may determine the deviation value (ΔKₜ). This may help in indicating the current tail as the deviation value (ΔKₜ) may be closer to zero because the deviation value (ΔKₜ) is determined based on the difference between the instant time constant (Kt) at the specific time instance (t) and the time constant (Kₜ₋₁) at preceding time instance (t-1). These time constants would be approximately same, leading to near-zero deviation value . Referring to graph **207** of **FIG. 2****,** the current tail is closer to zero which simplifies the process of detecting the current tail.

In an embodiment, upon determining the deviation value (ΔKₜ), the tail current detection unit **111** may be configured to compare the deviation value (ΔKₜ) with a predefined deviation threshold to determine whether the deviation value (ΔKₜ) is less than the predefined deviation threshold. As an example, the predefined deviation threshold may be, 0.02 per unit.

In an embodiment, based on the comparison, the tail current detection unit **111** may increment a counter each time when the deviation value (ΔKₜ) may be less than the predefined deviation threshold in consecutive time instances. Else, the tail current detection unit **111** may reset the counter to zero when the deviation value (ΔKₜ) may be greater than the predefined deviation threshold. As an example, consider an exemplary scenario in which the deviation value (ΔKₜ) is less than the predefined deviation threshold for two consecutive time instances, however, in the third time instance, the deviation value (ΔKₜ) is greater than the predefined deviation threshold. In such scenario, the counter is reset to zero. In other words, the counter is reset to zero whenever the deviation value (ΔKₜ) is greater than the predefined deviation threshold. The counter is reset to zero to restart the counter when the deviation value (ΔKₜ) may be less than the predefined deviation threshold in consecutive time instances. This process is continuously performed upon the comparison.

In an embodiment, the tail current detection unit **111** may detect presence of tail current in the CT **103** when the counter exceeds a predefined count threshold. As an example, the predefined count threshold may be, without limitation, eight. In some embodiments, the presence of tail current in the CT **103** may be detected when the deviation value (ΔKₜ) may be less than the predefined deviation threshold for a predefined duration. As an example, the predefined duration may be, without limitation, 5 milliseconds. As illustrated in graph **207** of **FIG. 2****,** the detection of current tail is indicated as the value changes to "1" from "0". In an embodiment, upon detecting the current tail, the tail current detection unit **111** may activate an output signal to indicate the presence of tail current. The output signal enables a switch **121** to supply a value "zero", instead of the current flowing in secondary side of the CT **103,** to one or more components using information of the current flowing in the secondary side of the CT **103.** The "zero" value is supplied to avoid generation of false alarms. If the actual current flowing in the secondary side of the CT is supplied, then the false alarms are generated as the one or more components would sense the decaying current and may generate alarms.

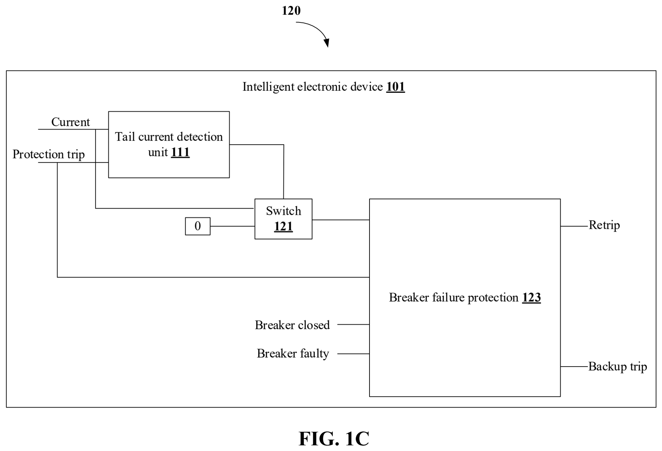

Referring to **FIG. 1C****,** which shows an exemplary illustration of the IED **101,** with tail current detection unit **111,** a switch **121** and a breaker failure protection **123.** In an embodiment, the switch **121** may be a logical component of the IED **101,** which may be activated to supply the value "zero" to one or more components in the secondary side of the CT **103** when the current tail is detected. In other words, in an ideal scenario, the one or more components may use the information of the current flowing in the secondary side of the CT **103.** When the current tail is detected, the output signal of the switch **121** may be activated to supply "zero", instead of the actual current (i.e., tail current) flowing in secondary side of the CT **103** (shown in **FIG. 1C****)** to avoid false alarm generation.

In an embodiment, end of the current tail may be determined by the tail current detection unit **111** by determining a Root Mean Square (RMS) value of the current flowing in the secondary side of the CT **103.** Further, the tail current detection unit **111** may determine end of the tail current in the CT **103,** when the RMS value of the current is substantially zero. The RMS may be determined using known methods. In an embodiment, upon detecting end of the current tail, the tail current detection unit **111** may reset the counter value to zero. Further, the tail current detection unit **111** may deactivate the output signal upon detection of the end of the tail current. The deactivation of the output signal may be stopping the supply of "zero" to the one or more components, which use the information of the current flowing in the secondary side of the CT **103.** When the output signal is deactivated, the current flowing in the secondary side of the CT **103** may be supplied to one or more components, which use information of the current flowing in the secondary side of the CT **103.**

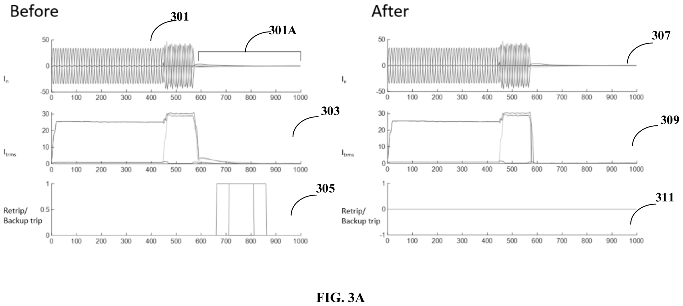

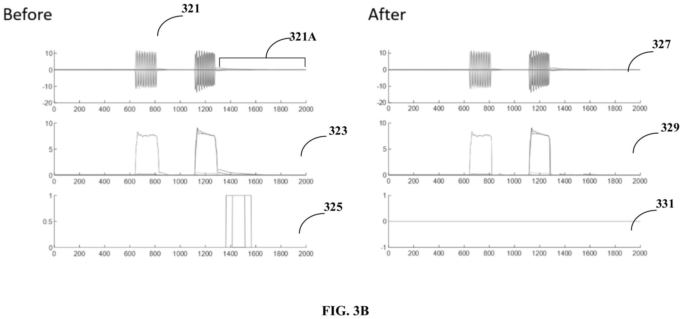

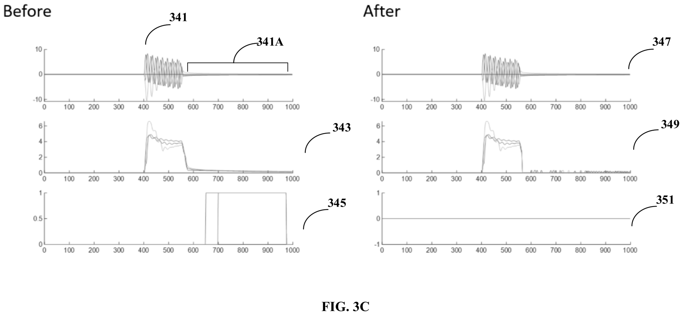

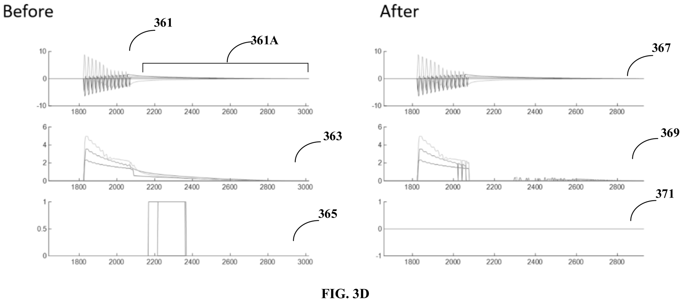

Referring to graphs shown in **FIGs 3A-3D****,** as shown in the graphs 301, 321, 341 and 361 the current tail is represented using **301A, 321A, 341A** and **361A** respectively.. The current tail can also be illustrated in graphs 303, 323, 343 and 363. The graphs 301-305, 321-325, 341-345 and 361-365 are related to absence of tail current detection. The graphs 307-311, 327-331, 347-351 and 367-371 are related to proposed technique. In the existing implementations, a re-trip or a backup-trip is issued since the current still remains in secondary side of the CT **103** (refer graphs 305, 325, 345 and 365) and it is passed to the one or more components using information of the current flowing in the secondary side of the CT. However, using the tail current detection unit **111,** the "zero" value is supplied to one or more components using information of the current flowing in the secondary side of the CT (i.e., the current tail is truncated (refer graphs 309, 329, 349 and 369)), this will avoid the issue of the re-trip or the backup-trip which may generate false alarms (refer graphs 311, 331, 351 and 371).

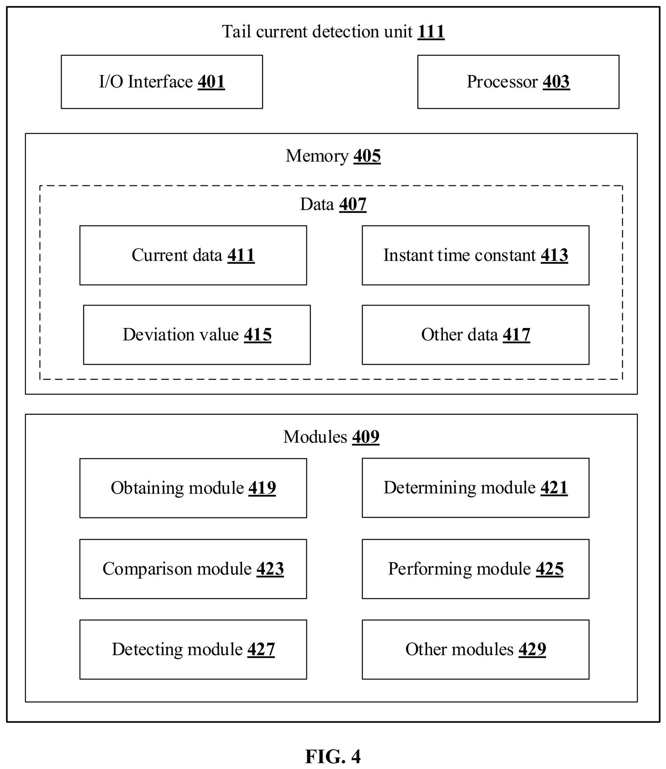

**FIG. 4** shows a detailed block diagram of a tail current detection unit **111** for detecting tail current in a Current Transformer (CT) **103,** in accordance with some embodiments of the present disclosure.

In some implementations, the tail current detection unit **111** may include an I/O interface **401,** a processor **403** and a memory **405.** In an embodiment, the memory **405** may be communicatively coupled to the processor **403.** The processor **403** may be configured to perform one or more functions of the tail current detection unit **111** to detect tail current in a Current Transformer (CT) **103,** using the data **407** and the one or more modules **409** of the tail current detection unit **111.** In an embodiment, the memory **405** may store data **407.**

In an embodiment, the data **407** stored in the memory **405** may include, without limitation, current data **411,** instant time constant **413,** deviation value **415** and other data **417.** In some implementations, the data **407** may be stored within the memory **405** in the form of various data structures. Additionally, the data **407** may be organized using data models, such as relational or hierarchical data models. The other data **417** may include various temporary data and files generated by the one or more modules **409.**

In an embodiment, the current data **411** may indicate real-time current values of current flowing in a secondary side of the CT **103.** In an embodiment, the current data **411** may be obtained using current sensor configured on the secondary side of the CT **103.** In some embodiments, the current data **411** may be determined based on the current value, voltage value and number of windings at primary and secondary side of the CT **103.** The current data **411** may be used to detect the current tail.

In an embodiment, the instant time constant **413** may be a value determined based on a ratio of instant current value (Iₜ) at a specific time instance (t) and current value (Iₜ₋₁) at preceding time instance (t-1). In other words, the instant time constant **413** may be determined using the current data **411.** The instant time constant **413** may be determined continuously as consecutive values of the instant time constant **413** may be used to determine the deviation value **415.** The instant time constant **413** may be determined using the equation 1.

In an embodiment, the deviation value **415** may be a value determined using pair of consecutive time constants. In an embodiment, the pair of consecutive time constants may be the instant time constant (Kₜ) at the specific time instance (t) and a time constant (Kₜ₋₁) at preceding time instance (t-1). In other words, the deviation value **415** may be determined using the instant time constant **413.** The deviation value (ΔKₜ) may be determined using difference between the instant time constant (Kₜ) at the specific time instance (t) and a time constant (Kₜ₋₁) at preceding time instance (t-1). The deviation value **415** may be determined continuously as the deviation value **415** may be used to detect the current tail. The deviation value **415** may be determined using the equation 2.

In an embodiment, the data **407** may be processed by one or more modules **409** of the tail current detection unit **111.** In some implementations, the one or more modules **409** may be communicatively coupled to the processor **403** for performing one or more functions of the tail current detection unit **111.** In an implementation, the one or more modules **409** may include, without limiting to, an obtaining module **419,** a determining module **421,** a comparison module **423,** a performing module **425,** a detecting module **427** and other modules **429.**

As used herein, the term module may refer to an Application Specific Integrated Circuit (ASIC), an electronic circuit, a hardware processor (shared, dedicated, or group) and memory that execute one or more software or firmware programs, a combinational logic circuit, and/or other suitable components that provide the described functionality. In an implementation, each of the one or more modules **409** may be configured as stand-alone hardware computing units. In an embodiment, the other modules **429** may be used to perform various miscellaneous functionalities on the tail current detection unit **111.** It will be appreciated that such one or more modules **409** may be represented as a single module or a combination of different modules.

In an embodiment, the obtaining module **419** may be configured for obtaining real-time current values of current flowing in a secondary side of the CT **103.** The real-time current values are measurements of current.

In an embodiment, the determining module **421** may be configured for determining an instant time constant (Kt). The instant time constant (Kt) may be a ratio of instant current value (Iₜ) at a specific time instance (t) and current value (Iₜ₋₁) at preceding time instance (t-1).

In an embodiment, the determining module **421** may be configured for determining a deviation value (ΔKₜ) by using pair of consecutive time constants. The pair of consecutive time constants may be the instant time constant (Kₜ) at the specific time instance (t) and a time constant (Kₜ₋₁) at preceding time instance (t-1).

In an embodiment, the comparison module **423** may be configured for comparing the deviation value (ΔKₜ) with a predefined deviation threshold to determine whether the deviation value (ΔKₜ) is less than the predefined deviation threshold.

In an embodiment, the performing module **425** may be configured for performing one of, incrementing a counter each time when the deviation value (ΔKₜ) is less than the predefined deviation threshold in consecutive time instances and resetting the counter to zero when the deviation value (ΔKₜ) is greater than the predefined deviation threshold.

In an embodiment, the detecting module **427** may be configured for detecting presence of tail current in the CT **103** when the counter exceeds a predefined count threshold. In an embodiment, upon detecting the presence of tail current in the CT **103,** an output signal may be activated to indicate the presence of tail current. The output signal enables a switch **121** to supply a value "zero", instead of the current flowing in secondary side of the CT **103,** to one or more components using information of the current flowing in the secondary side of the CT **103.** In an embodiment, the determining module **421** may be configured for determining a Root Mean Square (RMS) value of the current flowing in the secondary side of the CT **103.** Further, the determining module **421** may be configured for determining end of the tail current in the CT **103,** when the RMS value of the current is substantially zero. In an embodiment, upon determining the end of the tail current, a counter value may be reset to zero. Further, the output signal may be deactivated to indicate the end of the tail current. When the output signal is deactivated, the current flowing in the secondary side of the CT **103** is supplied to one or more components using information of the current flowing in the secondary side of the CT **103.**

Consider an exemplary working of the present disclosure with example values. The obtaining module **419** obtains current value at three time instances, i.e., t, t-1 and t-2. The corresponding current values at the time instances are given below: ${I}_{t} = 3.63536$ ${I}_{t - 1} = 3.65816$ ${I}_{t - 2} = 3.68109$

Further, the determining module **421** may determine the instant time constant (Kₜ). The determining module **421** determines the instant time constant (Kt) at two time instances, i.e., t, t-1. The instant time constants are provided below: ${k}_{t} = {I}_{t} / {I}_{t - 1} = 3.63536 / 3.65816 = 0.993769$ ${k}_{t - 1} = {I}_{t - 1} / {I}_{t - 2} = 3.65816 / 3.68109 = 0.993769$

Upon determining the instant time constant (Kt), the determining module **421** may determine the deviation value (ΔKₜ) by using pair of consecutive time constants. The deviation value (ΔKₜ) is provided below: ${Δk}_{t} = {k}_{t} - {k}_{t - 1} = 0$

In an embodiment, the performing module **425** may increment the counter each time when the deviation value (ΔKₜ) is less than the predefined deviation threshold in consecutive time instances. In an embodiment, the detecting module **427** may detect presence of tail current in the CT **103** when the counter exceeds a predefined count threshold. Upon detecting the presence of the current tail, the output signal may be activated to indicate the presence of tail current. The output signal enables a switch **121** to supply a value "zero", instead of the current flowing in secondary side of the CT **103,** to one or more components using information of the current flowing in the secondary side of the CT **103.** The supply of the current is stopped as there is no supply of current from primary side of the CT **103** and the current which is received may be decay current.

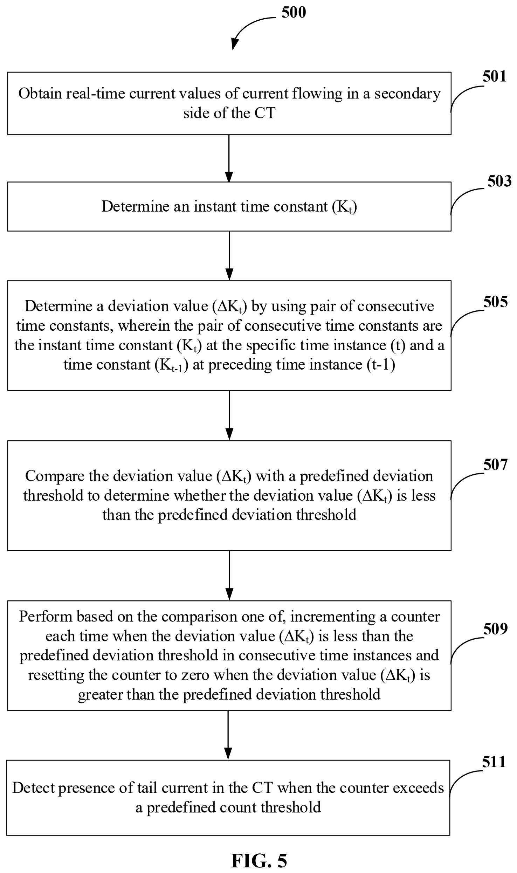

**FIG. 5** shows a flowchart illustrating a method of detecting tail current in a Current Transformer (CT) **103,** in accordance with some embodiments of the present disclosure.

As illustrated in **FIG. 5****,** the method **500** may include one or more blocks illustrating a method of detecting tail current in a CT **103** using a tail current detection unit **111** illustrated in **FIG.** 4. The method **500** may be described in the general context of computer executable instructions. Generally, computer executable instructions can include routines, programs, objects, components, data structures, procedures, modules, and functions, which perform specific functions or implement specific abstract data types.

The order in which the method **500** is described is not intended to be construed as a limitation, and any number of the described method blocks can be combined in any order to implement the method. Additionally, individual blocks may be deleted from the methods without departing from the scope of the subject matter described herein. Furthermore, the method can be implemented in any suitable hardware, software, firmware, or combination thereof.

At block **501,** the method **500** includes obtaining, by a processor **403** associated with the tail current detection unit **111,** real-time current values of current flowing in a secondary side of the CT **103.** The real-time current values are measurements of current. In an embodiment, the real-time measurements may be obtained upon activation of a trip signal by one or more protection functions **117_{N}** in Intelligent Electronic Device (IED) **101.** The IED **101** may be electrically coupled with the CT **103.**

At block **503,** the method **500** includes determining, by the processor **403,** an instant time constant (Kt). The instant time constant (Kₜ) may be ratio of instant current value (Iₜ) at a specific time instance (t) and current value (Iₜ₋₁) at preceding time instance (t-1).

At block **505,** the method **500** includes determining, by the processor **403,** a deviation value (ΔKₜ) by using pair of consecutive time constants. The pair of consecutive time constants may be the instant time constant (Kₜ) at the specific time instance (t) and a time constant (Kₜ₋₁) at preceding time instance (t-1).

At block **507,** the method **500** includes comparing, by the processor **403,** the deviation value (ΔKₜ) with a predefined deviation threshold to determine whether the deviation value (ΔKₜ) is less than the predefined deviation threshold.

At block **509,** based on comparison the method **500** includes performing, by the processor **403,** one of, incrementing a counter each time when the deviation value (ΔKₜ) is less than the predefined deviation threshold in consecutive time instances and resetting the counter to zero when the deviation value (ΔKₜ) is greater than the predefined deviation threshold.

At block **511,** the method **500** includes detecting, by the processor **403,** presence of tail current in the CT **103** when the counter exceeds a predefined count threshold. In an embodiment, the processor **403** may activate an output signal to indicate the presence of tail current. The output signal enables a switch **121** to supply a value "zero", instead of the current flowing in secondary side of the CT **103,** to one or more components using information of the current flowing in the secondary side of the CT **103.** In an embodiment, the processor **403** may determine a Root Mean Square (RMS) value of the current flowing in the secondary side of the CT **103.** Further, the processor **403** may determine end of the tail current in the CT **103,** when the RMS value of the current is substantially zero. Thereafter, the processor **403** may reset a counter value to zero upon determining the end of the tail current. Finally, the processor **403** may deactivate an output signal to indicate the end of the tail current. When the output signal is deactivated, the current flowing in the secondary side of the CT **103** may be supplied to one or more components using information of the current flowing in the secondary side of the CT **103.** The processor **403** may detect the tail current in a timely manner to avoid generation of false alarms and false operations caused by the tail current.

In light of the technical advancements provided by the disclosed method, the claimed steps, as discussed above, are not routine, conventional, or well-known aspects in the art, as the claimed steps provide the aforesaid solutions to the technical problems existing in the conventional technologies. Further, the claimed steps clearly bring an improvement in the functioning of the system itself, as the claimed steps provide a technical solution to a technical problem.

The terms "an embodiment", "embodiment", "embodiments", "the embodiment", "the embodiments", "one or more embodiments", "some embodiments", and "one embodiment" mean "one or more (but not all) embodiments of the invention(s)" unless expressly specified otherwise.

The terms "including", "comprising", "having" and variations thereof mean "including but not limited to", unless expressly specified otherwise.

The enumerated listing of items does not imply that any or all the items are mutually exclusive, unless expressly specified otherwise. The terms "a", "an" and "the" mean "one or more", unless expressly specified otherwise.

A description of an embodiment with several components in communication with each other does not imply that all such components are required. On the contrary, a variety of optional components are described to illustrate the wide variety of possible embodiments of the invention.

When a single device or article is described herein, it will be clear that more than one device/article (whether they cooperate) may be used in place of a single device/article. Similarly, where more than one device/article is described herein (whether they cooperate), it will be clear that a single device/article may be used in place of the more than one device/article, or a different number of devices/articles may be used instead of the shown number of devices or programs. The functionality and/or features of a device may be alternatively embodied by one or more other devices which are not explicitly described as having such functionality/features. Thus, other embodiments of invention need not include the device itself.

Finally, the language used in the specification has been principally selected for readability and instructional purposes, and it may not have been selected to delineate or circumscribe the inventive subject matter. It is therefore intended that the scope of the invention be limited not by this detailed description, but rather by any claims that issue on an application based here on. Accordingly, the embodiments of the present invention are intended to be illustrative, but not limiting, of the scope of the invention, which is set forth in the following claims.

While various aspects and embodiments have been disclosed herein, other aspects and embodiments will be apparent to those skilled in the art. The various aspects and embodiments disclosed herein are for purposes of illustration and are not intended to be limiting, with the true scope and spirit being indicated by the following claims.

### Referral Numerals:

| **Reference Number** | **Description** |
|---|---|
| 100 | Architecture |
| 101 | Intelligent Electronic Device (IED) |
| 103 | Current Transformer (CT) |
| 105 | Power system |
| 111 | Tail current detection unit |
| 113 | Analog to Digital Converter (ADC) |
| 115 | System measurements |
| 121 | Switch |
| 123 | Breaker failure protection |
| 401 | I/O Interface |
| 403 | Memory |
| 405 | Data |
| 407 | Processor |
| 409 | Modules |
| 411 | Current data |
| 413 | Instant time constant |
| 415 | Deviation value |
| 417 | Other data |
| 419 | Obtaining module |
| 421 | Determining module |
| 423 | Comparison module |
| 425 | Performing module |
| 427 | Detecting module |
| 429 | Other modules |

## Claims

1. A method of detecting tail current in a Current Transformer (CT), the method comprising:
obtaining real-time current values of current flowing in a secondary side of the CT;
determining an instant time constant (Kt), wherein the instant time constant (Kt) is ratio of instant current value (It) at a specific time instance (t) and current value (Iₜ₋₁) at preceding time instance (t-1);
determining a deviation value (ΔKₜ) by using pair of consecutive time constants, wherein the pair of consecutive time constants are the instant time constant (Kₜ) at the specific time instance (t) and a time constant (Kₜ₋₁) at preceding time instance (t-1);
comparing the deviation value (ΔKₜ) with a predefined deviation threshold to determine whether the deviation value (ΔKₜ) is less than the predefined deviation threshold;
based on the comparison, performing one of:
incrementing a counter each time when the deviation value (ΔKₜ) is less than the predefined deviation threshold in consecutive time instances; and
resetting the counter to zero when the deviation value (ΔKₜ) is greater than the predefined deviation threshold; and
detecting presence of tail current in the CT when the counter exceeds a predefined count threshold.

2. The method as claimed in claim 1, further comprises:
activating an output signal to indicate the presence of tail current, wherein the output signal enables a switch to supply a value "zero", instead of the current flowing in secondary side of the CT, to one or more components using information of the current flowing in the secondary side of the CT.

3. The method as claimed in any one of claims 1 or 2, further comprises:
determining a Root Mean Square (RMS) value of the current flowing in the secondary side of the CT; and
determining end of the tail current in the CT, when the RMS value of the current is substantially zero.

4. The method as claimed in claim 3, further comprising:
resetting a counter value to zero upon determining the end of the tail current; and
deactivating an output signal to indicate the end of the tail current, wherein when the output signal is deactivated, the current flowing in the secondary side of the CT is supplied to one or more components using information of the current flowing in the secondary side of the CT.

5. The method as claimed in any one of claims 1 through 4, wherein the real-time measurements are obtained upon activation of a trip signal by one or more protection functions in a relay that is electrically coupled with the CT.

6. A tail current detection unit for detecting tail current in Current Transformer (CT), the tail current detection unit comprising:
a processor; and
a memory communicatively coupled to the processor, wherein the memory stores processor instructions, which, on execution, causes the processor to:
obtain real-time current values of current flowing in a secondary side of the CT;
determine an instant time constant (Kₜ) wherein the instant time constant (Kt) is ratio of instant current value (It) at a specific time instance (t) and current value (Iₜ₋₁) at preceding time instance (t-1);
determine a deviation value (ΔKₜ) by using pair of consecutive time constants, wherein the pair of consecutive time constants are the instant time constant (Kt) at the specific time instance (t) and a time constant (Kₜ₋₁) at preceding time instance (t-1);
compare the deviation value (ΔKₜ) with a predefined deviation threshold to determine whether the deviation value (ΔKₜ) is less than the predefined deviation threshold;
based on the comparison, perform one of:
increment a counter each time when the deviation value (ΔKₜ) is less than the predefined deviation threshold in consecutive time instances; and
reset the counter to zero when the deviation value (ΔKₜ) is greater than the predefined deviation threshold; and
detect presence of tail current in the CT when the counter exceeds a predefined count threshold.

7. The tail current detection unit as claimed in claim 6, wherein the processor is further configured to:
activate an output signal to indicate the presence of tail current, wherein the output signal enables a switch to supply a value "zero", instead of the current flowing in secondary side of the CT, to one or more components using information of the current flowing in the secondary side of the CT.

8. The tail current detection unit as claimed in any one of claims 6 or 7, wherein the processor is further configured to:
determine a Root Mean Square (RMS) value of the current flowing in the secondary side of the CT; and
determine end of the tail current in the CT, when the RMS value of the current is substantially zero.

9. The tail current detection unit as claimed in claim 8, wherein the processor is further configured to:
reset a counter value to zero upon determining the end of the tail current; and
deactivate output signal to indicate the end of the tail current, wherein when the output signal is deactivated, the current flowing in the secondary side of the CT is supplied to one or more components using information of the current flowing in the secondary side of the CT.

10. The tail current detection unit as claimed in any one of claims 6 through 9, wherein the processor obtains real-time measurements upon activation of a trip signal by one or more protection functions in a relay that is electrically coupled with the CT.

11. An Intelligent Electronic Device for detecting tail current in Current Transformer (CT), the IED comprising:
an Analog to Digital Converter (ADC);
a system measurement;
one or more protection functions; and
a tail current detection unit, wherein the tail current detection unit is configured to:
obtain real-time current values of current flowing in a secondary side of the CT;
determine an instant time constant (Kₜ) wherein the instant time constant (Kt) is ratio of instant current value (It) at a specific time instance (t) and current value (Iₜ₋₁) at preceding time instance (t-1);
determine a deviation value (ΔKₜ) by using pair of consecutive time constants, wherein the pair of consecutive time constants are the instant time constant (Kt) at the specific time instance (t) and a time constant (Kₜ₋₁) at preceding time instance (t-1);
compare the deviation value (ΔKₜ) with a predefined deviation threshold to determine whether the deviation value (ΔKₜ) is less than the predefined deviation threshold;
based on the comparison, perform one of:
increment a counter each time when the deviation value (ΔKₜ) is less than the predefined deviation threshold in consecutive time instances; and
reset the counter to zero when the deviation value (ΔKₜ) is greater than the predefined deviation threshold; and
detect presence of tail current in the CT when the counter exceeds a predefined count threshold.

12. The IED as claimed in claim 11, wherein the tail current detection unit is further configured to:
activate an output signal to indicate the presence of tail current, wherein the output signal enables a switch to supply a value "zero", instead of the current flowing in secondary side of the CT, to one or more components using information of the current flowing in the secondary side of the CT.

13. The IED as claimed in any one of claims 11 or 12, wherein the tail current detection unit is further configured to:
determine a Root Mean Square (RMS) value of the current flowing in the secondary side of the CT; and
determine end of the tail current in the CT, when the RMS value of the current is substantially zero.

14. The IED as claimed in claim 13, wherein the tail current detection unit is further configured to:
reset a counter value to zero upon determining the end of the tail current; and
deactivate output signal to indicate the end of the tail current, wherein when the output signal is deactivated, the current flowing in the secondary side of the CT is supplied to one or more components using information of the current flowing in the secondary side of the CT.

15. The IED as claimed in any one of claims 11 through 14, wherein the tail current detection unit obtains real-time measurements upon activation of a trip signal by one or more protection functions in a relay that is electrically coupled with the CT.
